# EUROPÄISCHE PATENTANMELDUNG

(11) **EP 1 729 417 A2**
(43) Veröffentlichungstag der Anmeldung: **06.12.2006**
(21) Anmeldenummer: 06009193.1
(22) Anmeldetag: 04.05.2006
(51) Int. Cl.: H03K 17/96

(54) **Berührungsempfindlicher Tastschalter**

(30) Priorität: 04.06.2005 DE 102005025782
(71) Anmelder: Diehl AKO Stiftung & Co. KG, 88239 Wangen (DE)
(72) Erfinder: Arnold, Georg, 91126 Schwabach (DE)
(74) Vertreter: Diehl Patentabteilung

(57) **Zusammenfassung**

Es wird ein berührungsempfindlicher Tastschalter (10) mit einem optischen Sensor (14, 16), insbesondere einem Infrarot-Sensor, und einer Auswerteschaltung (40) vorgeschlagen, wobei die Auswerteschaltung (40) in der Lage ist, eine Fehlfunktion des optischen Sensors (14, 16) zu erkennen, sodass der Tastschalter (10) aus Sicherheitsgründen zum Beispiel ausgeschaltet werden kann.

## Beschreibung

Die vorliegende Erfindung betrifft einen berührungsempfindlichen Tastschalter nach dem Oberbegriff des Anspruchs 1 bzw. des Anspruchs 4, und insbesondere einen solchen Tastschalter zur Verwendung in einer Bedienungseinrichtung eines Haushaltsgeräts.

Der grundsätzliche Aufbau und das Grundprinzip eines solchen berührungsempfindlichen Tastschalters sind zum Beispiel aus der DE 40 07 971 A1 bekannt. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Ferner ist im Allgemeinen eine Auswerteschaltung zum Auswerten eines von dem Empfänger erzeugten Messsignals und Erzeugen eines Auswertesignals zur weiteren Verarbeitung vorgesehen. Eine vorteilhafte Anwendung derartiger berührungsempfindlicher Tastschalter ist zum Beispiel der Einsatz in Bedienungseinrichtungen von Haushaltsgeräten, wie Kochherden, Glaskeramik-Kochfeldern, Mikrowellenherden und dergleichen, bei denen der Tastschalter zur einfachen Bedienung und Reinigung hinter einer Abdeckung, wie beispielsweise einer Glasplatte oder Glaskeramikplatte untergebracht ist.

Bei herkömmlichen Tastschaltern dieser Art besteht ein Problem dahingehend, dass nicht erkannt werden kann, ob der optische Sensor, d.h. insbesondere der Sender und/oder der Empfänger, des Tastschalters defekt ist. Dies stellt zum Beispiel dann auch ein Sicherheitsrisiko dar, wenn der Tastschalter erst nach dem erfolgreichen Einschalten fehlerhaft wird und daher nicht mehr ausgeschaltet werden kann. Es besteht daher Bedarf an einem berührungsempfindlichen Tastschalter der eingangs genannten Art, bei dem eine Fehlfunktion des optischen Sensors erkannt werden kann, sodass schließlich gegebenenfalls auf eine solche erkannte Fehlfunktion angemessen reagiert werden kann.

Der vorliegenden Erfindung liegt daher die Aufgabe zugrunde, einen berührungsempfindlichen Tastschalter bereitzustellen, bei dem eine Fehlfunktion seines optischen Sensors erkannt werden kann.

Gemäß einem ersten Aspekt der Erfindung wird diese Aufgabe gelöst durch einen berührungsempfindlichen Tastschalter mit den Merkmalen des Anspruchs 1. Vorteilhafte Ausgestaltungen und Weiterbildungen dieses Tastschalters sind Gegenstand der abhängigen Ansprüche 2 und 3.

Der erfindungsgemäße Tastschalter zeichnet sich dadurch aus, dass ferner eine Einrichtung zum Leiten eines Teils der von dem Sender ausgesendeten elektromagnetischen Strahlung auch ohne Betätigung des Tastschalters zum Empfänger vorgesehen ist; und dass die Auswerteschaltung in Abhängigkeit von einem erfassten Grundpegel des Auswertesignals eine Fehlfunktion des optischen Sensors beurteilt, wenn während eines Sendetakts des Senders keine Änderung des Auswertesignalpegels der Auswerteschaltung erfasst wird.

Durch den obigen Aufbau des Tastschalters wird erreicht, dass der Empfänger auch ohne Betätigung des Tastschalters eine kleine Strahlungsmenge empfängt und so ein entsprechendes Messsignal erzeugt. Wird dieses Messsignal nicht erzeugt, so kann durch die Auswerteschaltung auf eine Fehlfunktion des optischen Sensors geschlossen werden. Dabei muss jedoch auch der Grundpegel des Auswertesignals berücksichtigt werden, da zum Beispiel im Fall einer Überstrahlung auch bei einem funktionierenden optischen Sensor keine Änderung des Auswertesignalpegels (mit oder ohne Betätigung des Tastschalters) erfasst werden kann.

In einer Ausgestaltung der Erfindung weist die Einrichtung eine zumindest teildurchlässige Durchgangsöffnung einer Trennwand eines Blendenrahmens zwischen dem Sender und dem Empfänger auf, sodass unabhängig von einer Betätigung des Tastschalters immer ein Teil der von dem Sender ausgesendeten Strahlung direkt durch diese Durchgangsöffnung zum Empfänger gelangt.

In einer alternativen Ausgestaltung der Erfindung weist die Einrichtung die Abdeckung auf, die derart ausgebildet ist, dass ein Teil der von dem Sender ausgesendeten Strahlung an der vorderen und/oder der hinteren Oberfläche der Abdeckung in Richtung zum Empfänger reflektiert wird. Dies kann zum Beispiel durch die Wahl eines speziellen Brechungsindex des Materials der Abdeckung, durch eine spezielle Beschaffenheit der Oberflächen oder durch eine spezielle Beschichtung der Oberflächen der Abdeckung erreicht werden.

Gemäß einem zweiten Aspekt der Erfindung wird die obige Aufgabe gelöst durch einen berührungsempfindlichen Tastschalter mit den Merkmalen des Anspruchs 4. Vorteilhafte Ausgestaltungen und Weiterbildungen dieses Tastschalters sind in den abhängigen Ansprüchen 5 bis 7 angegeben.

Der erfindungsgemäße Tastschalter zeichnet sich dadurch aus, dass die AuswerteSchaltung ferner eine Einrichtung zum Umschalten eines Messbereichs des Auswertesignals aufweist; und dass die Auswerteschaltung in Abhängigkeit von einem erfassten Grundpegel des Auswertesignals eine Fehlfunktion des optischen Sensors beurteilt, wenn während eines Umschalttakts des Messbereichs der Grundpegel des Auswertesignals keine Änderung des Auswertesignalpegels der Auswerteschaltung erfasst.

Durch den obigen Aufbau der Auswerteschaltung ist es möglich, zum Zwecke der Messung der Sättigungsspannung des Empfängers einen Messbereich umzuschalten, was einen Spannungssprung im Auswertesignal bewirkt. Wird dieser Spannungssprung nicht erzeugt, so kann durch die Auswerteschaltung auf eine Fehlfunktion des optischen Sensors geschlossen werden. Solch ein Spannungssprung kann grundsätzlich nicht erzeugt werden, wenn zum Beispiel der Empfänger fehlerhafterweise auf dem Niveau der Versorgungsspannung liegt, oder der Empfänger kurzgeschlossen ist.

In einer Ausgestaltung der Erfindung weist die Auswerteschaltung eine Spannungsteilerschaltung auf, die aus einem ersten Widerstand und einem ersten Transistor gebildet wird, wobei der erste Transistor durch das Messsignal des Empfängers gesteuert wird und das Auswertesignal der Auswerteschaltung zwischen dem ersten Widerstand und dem ersten Transistor abgegriffen wird. In diesem Fall ist die Einrichtung eine Einrichtung zum Verändern des Spannungsteilungsverhältnisses.

In einer weiteren Ausgestaltung der Erfindung weist die Einrichtung eine Reihenschaltung eines zweiten Transistors und eines zweiten Widerstandes auf, die parallel zu dem ersten Widerstand geschaltet ist, wobei der zweite Transistor während des Umschalttakts leitend gesteuert wird. Zusätzlich ist in der Auswerteschaltung parallel zu dem ersten Transistor ein dritter Widerstand geschaltet.

Gemäß einem dritten Aspekt der Erfindung kann die oben genannte Aufgabe natürlich auch durch eine Kombination des ersten und des zweiten Aspekts gelöst werden. Dabei ist in dem Tastschalter eine Einrichtung zum Leiten eines Teils der von dem Sender ausgesendeten elektromagnetischen Strahlung auch ohne Betätigung des Tastschalters zum Empfänger vorgesehen und die Auswerteschaltung weist ferner eine Einrichtung zum Umschalten eines Messbereichs des Auswertesignals auf, sodass die Auswerteschaltung in Abhängigkeit von einem erfassten Grundpegel des Auswertesignals eine Fehlfunktion des optischen Sensors beurteilen kann, wenn während eines Sendetakts des Senders und/oder während eines Umschalttakts des Messbereichs des Auswertesignals keine Änderung des Auswertesignalpegels der Auswerteschaltung erfasst wird.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:
- Fig. 1: eine Schnittansicht des Aufbaus eines berührungsempfindlichen Tastschalters gemäß einem bevorzugten Ausführungsbeispiel der vorliegenden Erfindung;
- Fig. 2: einen vereinfachten Schaltplan einer herkömmlichen Auswerteschaltung;
- Fig. 3: einen vereinfachten Schaltplan einer Auswerteschaltung des berührungs-empfindlichen Tastschalters gemäß einem bevorzugten Ausführungsbeispiel der vorliegenden Erfindung;
- Fig. 4 und 5: schematische Signaldiagramme zur Erläuterung des Signalverlaufs eines Auswertesignals der Auswerteschaltung von Fig. 3 gemäß der vorliegenden Erfindung im Fall eines funktionsfähigen optischen Sensors des berührungsempfindlichen Tastschalters; und
- Fig. 6 bis 8: schematische Signaldiagramme zur Erläuterung des Signalverlaufs eines Auswertesignals der Auswerteschaltung von Fig. 3 gemäß der vorliegenden Erfindung im Fall eines fehlerhaften optischen Sensors des berührungsempfindlichen Tastschalters.

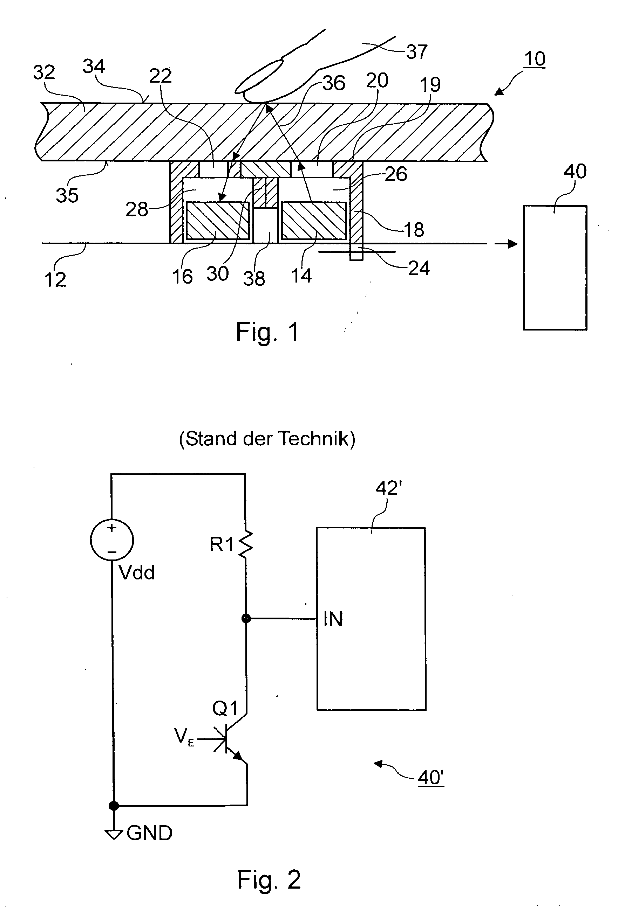

Anhand von Fig. 1 wird zunächst der mechanische Aufbau eines berührungsempfindlichen Tastschalters 10 der Erfindung näher erläutert. Der berührungsempfindliche Tastschalter der Erfindung ist zum Beispiel ein Infrarot-Tastschalter für ein Haushaltsgerät, wie einen Kochherd, einen Mikrowellenherd, ein Kochfeld, eine Waschmaschine, einen Wäschetrockner, eine Spülmaschine oder dergleichen, ohne dass die Erfindung auf eine elektromagnetische Strahlung dieses Wellenlängenbereichs oder diese spezielle Anwendungen beschränkt ist.

Der berührungsempfindliche Tastschalter 10 weist auf einer Leiterplatte 12 einen Infrarot-Sender 14 und einen Infrarot-Empfänger 16 auf. Der Sender 14 und der Empfänger 16 sind von einem Blendenrahmen 18 umgeben, der an seiner Oberseite 19 zwei Öffnungen 20 und 22 aufweist. Der aus einem Infrarot-undurchlässigen Material gebildete Blendenrahmen 18 ist mit Füßen 24 durch Löcher in der Leiterplatte 12 eingesteckt und so an dieser befestigt.

Der Sender 14 und der Empfänger 16 sind so in dem Blendenrahmen 18 positioniert, dass sie innerhalb von jeweiligen Hohlräumen 26 und 28 unterhalb der Blendenöffnungen 20 und 22 angeordnet sind. Die beiden Hohlräume 26 und 28 sind dabei durch eine Infrarot-undurchlässige Trennwand 30 voneinander getrennt. Direkt auf der Oberseite 19 des Blendenrahmens 18 liegt eine Abdeckung 32 aus einem zumindest Infrarot-teildurchlässigen Material, zum Beispiel eine Glaskeramikplatte eines Haushaltskochherdes.

Die von dem Sender 14 ausgesendete Strahlung gelangt über einen optischen Weg 36 zur Oberseite 34 der Abdeckung 32. Bei einer Betätigung des berührungsempfindlichen Tastschalters 10 durch einen auf die Oberfläche der Abdeckung 32 gelegten Finger 37 wird die Strahlung des Senders 14 diffus und mehrfach reflektiert, sodass genügend Streustrahlung auf den Empfänger 16 reflektiert wird und dieser ein entsprechendes Messsignal V_{E} an eine Auswerteschaltung 40 sendet, um eine entsprechende Schaltfunktion auszulösen.

Im Fall einer herkömmlichen Auswerteschaltung 40', wie sie in Fig. 2 veranschaulicht ist, würde dieses Messsignal V_{E} einen ersten Transistor Q1 einer Spannungsteilerschaltung schalten, die aus einem ersten Widerstand R1 und dem ersten Transistor Q1 aufgebaut ist und an die eine Versorgungsspannung Vdd angelegt ist. Der Transistor Q1 fungiert hierbei als Empfänger. Das Auswertesignal V_{IN} wird zwischen dem ersten Widerstand R1 und dem ersten Transistor Q1 abgegriffen und einem Mikroprozessor 42' zur weiteren Verarbeitung zugeführt. Im Fall eines funktionsfähigen Tastschalters 10 ist ohne Betätigung des Tastschalters 10 der erste Transistor Q1 hochohmig, sodass das Auswertesignal V_{IN} einen hohen Signalpegel besitzt. Bei einer Betätigung des Tastschalters 10 wird der erste Transistor 10 durch das Messsignal V_{E} des Empfängers 16 niederohmig geschaltet, sodass der Signalpegel des Auswertesignals V_{IN} entsprechend abfällt, was von dem Mikroprozessor 42' als eine Betätigung des Tastschalters 10 interpretiert wird.

Im Fall eines Defekts des optischen Sensors 14, 16 oder des Widerstands R1 oder anderer Komponenten des Tastschalters 10 kann der Mikroprozessor 42' keine Betätigung des Tastschalters 10 mehr erkennen. Außerdem ist es mit der herkömmlichen Auswerteschaltung 40' nicht möglich, einen solchen Defekt des optischen Sensors 14, 16 zu erkennen und entsprechend darauf zu reagieren, was in manchen Fällen ein Sicherheitsrisiko darstellen kann, wenn zum Beispiel eine Herdplatte nicht mehr abgeschaltet werden kann.

Um die Betriebssicherheit des berührungsempfindlichen Tastschalters 10 zu erhöhen, sind gemäß der vorliegenden Erfindung daher die folgenden Maßnahmen getroffen.

Wie in Fig. 1 angedeutet, weist die Trennwand 30 des Blendenrahmens 18 eine Durchgangsöffnung 38 auf, die für die von dem Sender 14 ausgesendete elektromagnetische Strahlung zumindest teildurchlässig ist. Zusätzlich oder alternativ können die Oberseite 34 und/oder die Unterseite 35 der Abdeckung 32 so beschaffen oder beschichtet sein, dass zumindest ein Teil der elektromagnetischen Strahlung des Senders 14 in Richtung zum Empfänger 16 reflektiert wird. Auf diese Weise wird als erste Maßnahme erreicht, dass der Empfänger 16 auch ohne eine Betätigung des Tastschalters 10 eine gewisse Strahlungsmenge vom Sender 14 empfängt und ein entsprechendes Messsignal V_{E} für die Auswerteschaltung 40 erzeugt.

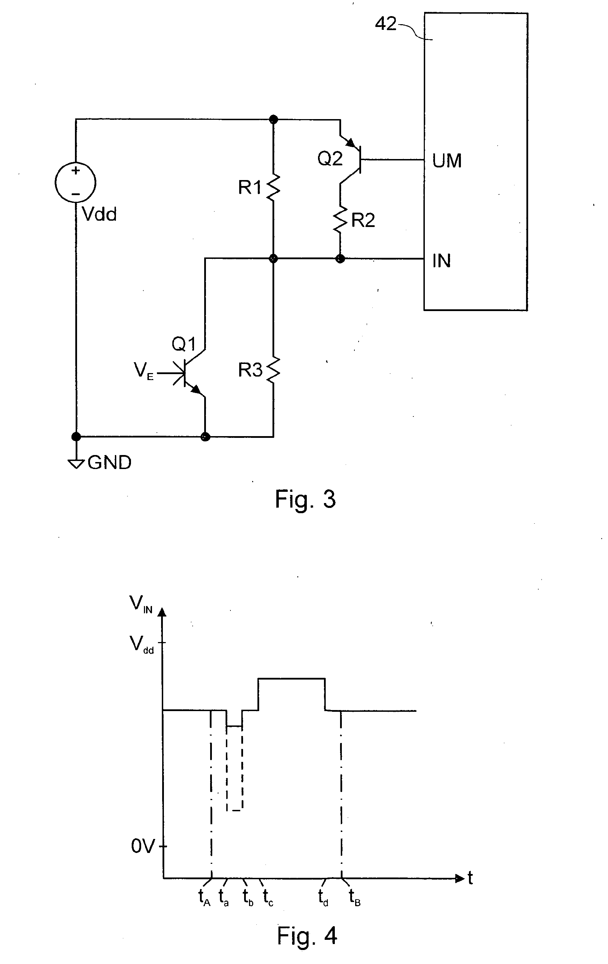

Als zweite Maßnahme ist eine Messbereichsumschaltung eingeführt, die die Auswerteschaltung 40 des berührungsempfindlichen Tastschalters 10 modifiziert, wie in Fig. 3 dargestellt.

Der Grundaufbau der erfindungsgemäßen Auswerteschaltung 40 ist auch hier eine Spannungsteilerschaltung, die aus einem ersten Widerstand R1 und einem ersten Transistor Q1 besteht, zwischen denen das Auswertesignal V_{IN} abgegriffen und einem Eingang IN des Mikroprozessors 42 zur weiteren Bearbeitung und Auswertung eingegeben wird. Zusätzlich ist parallel zu dem ersten Widerstand R1 eine Reihenschaltung aus einem zweiten Transistor Q2 und einem zweiten Widerstand R2 geschaltet, wobei der zweite Widerstand R2 sehr niederohmig (zum Beispiel wenige kΩ) gewählt ist und der zweite Transistor Q2 durch ein Umschaltsignal von einem Steuerausgang UM des Mikroprozessors 42 gesteuert wird. Vorzugsweise ist ferner parallel zu dem ersten Transistor Q1 ein dritter (bevorzugt hochohmiger) Widerstand R3 geschaltet.

Die Funktionsweise dieser modifizierten Spannungsteilerschaltung der Auswerteschaltung 40 ist wie folgt. Im Normalzustand, wenn der zweite Transistor Q2 kein Umschaltsignal von dem Mikroprozessor 42 empfängt und daher nicht-leitend ist, wird das Auswertesignal V_{IN} im Wesentlichen durch die aus, R1 und Q1 aufgebaute Spannungsteilung aufgebaut. Mit anderen Worten entspricht das Auswertesignal V_{IN} in diesem Schaltungszustand dem "normalen" Auswertesignal. Gibt der Mikroprozessor 42 dagegen das Umschaltsignal aus, wird der zweite Transistor Q2 leitend geschaltet, sodass die Spannungsteilung im Wesentlichen durch die niederohmige Reihenschaltung aus Q2 und R2 und durch den ersten Transistor Q1 bestimmt wird. Im Vergleich zu dem "normalen" Auswertesignal ist der Pegel des Auswertesignals V_{IN} aber nun in Richtung zur Versorgungsspannung Vdd verschoben. Der parallel zu dem ersten Transistor Q1 geschaltete dritte Widerstand R3 gewährleistet, dass die Verschiebung des Auswertesignalpegels V_{IN} durch das Umschaltsignal selbst bei Dunkelheit am Tastschalter 10 erzeugt werden kann.

Die beiden oben beschriebenen Maßnahmen, d.h. ein Messsignal V_{E} auch ohne Betätigung des Tastschalters 10 und ein Verschieben des Spannungsteilungsverhältnisses wird von der Auswerteschaltung 40 folgendermaßen zum Erkennen eines Defekts des optischen Sensors 14, 16 ausgenutzt.

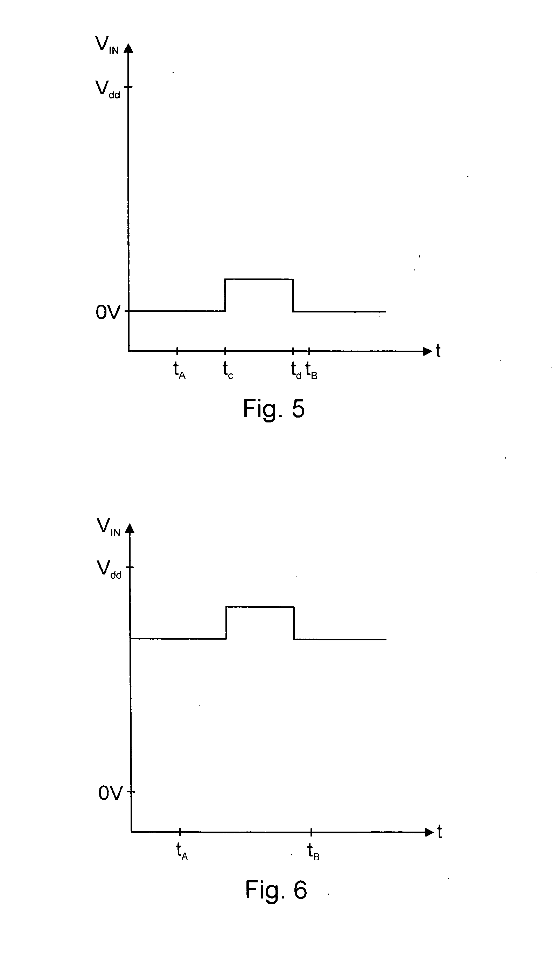

Unter Bezugnahme auf Fig. 4 und 5 wird nachfolgend zunächst der Signalverlauf eines Auswertesignals V_{IN} des erfindungsgemäßen Tastschalters 10 für den Fall eines funktionsfähigen optischen Sensors 14, 16 beschrieben.

Wie in Fig. 4 dargestellt, wird der Tastschalter 10 im Multiplexbetrieb im Zeitfenster t_{A} bis t_{B} ausgewertet. Innerhalb dieses Zeitfensters t_{A} - t_{B} existieren nacheinander ein Sendetakt tₐ bis t_{b}, in dem der Sender 14 Strahlung aussendet, und ein Umschalttakt t_{c} bis t_{d}, in dem der Mikroprozessor 42 das Umschaltsignal an den zweiten Transistor Q2 ausgibt. Außerhalb des Zeitfensters t_{A} -t_{B} ist der Multiplexerbetrieb auf andere Tastschalter der Bedienungseinrichtung geschaltet.

In einer anderen Ausführungsform ist, indem ohne Multiplexbetrieb gearbeitet wird, durch diese Schaltung auch nur eine einzige Taste bedien- und auswertbar.

Fig. 4 zeigt den Signalverlauf eines Auswertesignals V_{IN} ohne Betätigung des Tastschalters 10 und ohne Überstrahlung des Tastschalters 10. Als Reaktion auf die vom Sender 14 ausgesendete Strahlung erzeugt der Empfänger 16 ein Messsignal V_{E}, das zu einer leichten Erniedrigung des Auswertesignalpegels V_{IN} (Hub) während des Sendetakts tₐ - t_{b} führt. Dieser Erniedrigung des Auswertesignals V_{IN} wäre im Fall einer Tastschalterbetätigung deutlich stärker ausgeprägt, wie durch einen gestrichelten Signalverlauf in Fig. 4 angedeutet. Im Anschluss daran wird der Auswertesignalpegel V_{IN} während des Umschalttakts t_{c} - t_{d} in Richtung auf die Versorgungsspannung Vdd hin verschoben (Stufe). Der Grundpegel des Auswertesignals V_{IN} liegt dabei zwischen 0 V und Vdd näher zu Vdd.

Ist der Tastschalter 10, d.h. sein optischer Sensor durch Fremdlichteinfall stark überstrahlt, sodass der Grundpegel des Auswertesignals V_{IN} bis auf 0 V absinkt, wie in Fig. 5 veranschaulicht, so kann der oben beschriebene Hub während des Sendetakts tₐ - t_{b} von der Auswerteschaltung nicht erfasst werden. Andererseits kann die Auswerteschaltung 40 selbst in diesem Fall noch die Stufe während des Umschalttakts t_{c} - t_{d} erfassen. Trotz des fehlenden Hubs im Sendetakt tₐ - t_{b} kann daher die Auswerteschaltung 40 aufgrund der Stufe im Umschalttakt t_{c} - t_{d} erkennen, dass der optische Sensor 14, 16 funktionsfähig ist.

Bereits anhand der beiden Signalverläufe von Fig. 4 und Fig. 5 ist somit erkennbar, dass zur Beurteilung eines defekten optischen Sensors 14, 16 durch die Auswerteschaltung 40 der Grundpegel des Auswertesignals V_{IN} zu berücksichtigen ist. Abhängig vom Grundpegel des Auswertesignals V_{IN} sind verschiedene Indikatoren für die Beurteilung eines Defekts des optischen Sensors 14, 16 maßgebend.

Anhand der Fig. 6 bis 8 werden nun verschiedene Signalverläufe des Auswertesignals V_{IN} jeweils für einen fehlerhaften optischen Sensor 14, 16 bzw. einen defekten Tastschalter 10 beschrieben.

In dem Beispiel von Fig. 6 ist der Grundpegel des Auswertesignals V_{IN} auf dem Niveau des normalen Auswertesignals zwischen 0 V und Vdd. In dem Zeitfenster t_{A} - t_{B} dieses Tastschalters 10 ist allerdings nur die Stufe im Umschalttakt t_{c} - t_{d} erkennbar; ein Hub während des Sendetakts tₐ - t_{b} ist nicht vorhanden. Der Mikroprozessor 42 kann anhand dieses Auswertesignals V_{IN} beurteilen, dass der Tastschalter 10 defekt ist, genauer dass zum Beispiel der Sender 14 defekt ist oder dass ein Anschluss des Empfängers 16 offen ist.

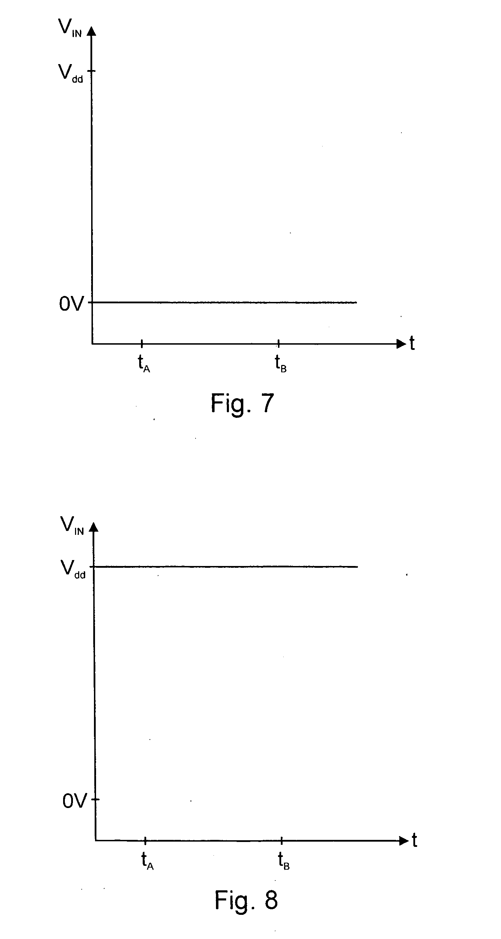

In Fig. 7 ist der Grundpegel des Auswertesignals V_{IN} auf 0 V abgesenkt und weder der Hub im Sendetakt tₐ - t_{b} noch die Stufe im Umschalttakt t_{c} - t_{d} sind vorhanden. In diesem Fall schließt der Mikroprozessor 42 ebenfalls auf einen defekten Tastschalter 10, genauer zum Beispiel auf einen kurzgeschlossenen Empfänger 16. Dieser Defekt wäre selbst bei einem überstrahlten Tastschalter 10 noch zu erfassen, da, wie in Fig. 5 dargestellt, bei einem funktionsfähigen Tastschalter 10 zumindest die Stufe während des Umschalttakts t_{c} - t_{d} existieren müsste.

Fig. 8 zeigt einen weiteren Fehlerfall des Tastschalters 10, bei dem der Empfänger 16 (oder ein anderes Bauteil) auf dem Niveau der Versorgungsspannung Vdd liegt. In diesem Fall wird der Grundpegel des Auswertesignals V_{IN} auf die Versorgungsspannung Vdd hochgezogen und es existiert weder ein Hub während des Sendetakts tₐ - t_{b} noch eine Stufe während des Umschalttakts t_{c} - t_{d}.

Der Fachmann wird problemlos den Signalverlauf des Auswertesignals V_{IN} erkennen, der sich bei anderen speziellen Fehlerfällen des Tastschalters 10 ergibt, die gegebenenfalls auftreten können, ohne dass im Rahmen dieser Anmeldung sämtliche Möglichkeiten diskutiert werden müssen.

Entscheidend bei der Beurteilung eines fehlerhaften Tastschalters 10 ist, dass neben dem Vorhandensein bzw. Nicht-Vorhandensein des Hubs während des Sendetakts tₐ - t_{b} und der Stufe während des Umschalttakts t_{c} - t_{d} auch der jeweilige Grundpegel des Auswertesignals V_{IN} mit berücksichtigt wird.

Außerdem ist es natürlich auch möglich, einen berührungsempfindlichen Tastschalter 10 mit nur einer Fehlererfassungsmaßnahme vorzusehen. Dies bedeutet zwar zwangsläufig, dass nicht alle möglichen Arten eines Defekts des Tastschalters 10 zweifelsfrei erkannt werden können, dies würde aber dennoch eine Verbesserung der herkömmlichen Tastschalter ohne irgendeine Fehlererfassung bedeuten.

Falls durch die obige Auswerteschaltung 40 ein fehlerhafter Tastschalter 10 beurteilt wird, können angemessene Maßnahmen ergriffen werden, wie beispielsweise ein automatisches Ausschalten des Geräts, um die Sicherheit zu erhöhen.

Zur weiteren Erhöhung der Betriebssicherheit ist es außerdem von Vorteil, wenn ein einmal erkannter Fehler des Tastschalters 10 zum Beispiel in Form eines entsprechenden Merkers abgespeichert wird, sodass zu einem späteren Zeitpunkt dieser Fehler erkannt wird, selbst wenn er zum Beispiel aufgrund eines gerade überstrahlten optischen Sensors nicht erfasst werden könnte. Bei einer Reparatur des Tastschalters 10 könnten diese Merker natürlich zurückgesetzt werden.

Grundsätzlich können die Schaltungen der Fig. 2 und 3 auch in vertauschter Polarität ausgeführt sein, was für die Darstellung der Fig. 4 bis 8 ebenfalls eine umgekehrte Polarität bedeutet.

### BEZUGSZIFFERNLISTE

- 10: Tastschalter
- 12: Leiterplatte
- 14: Sender
- 16: Empfänger
- 18: Blendenrahmen
- 19: Oberseite des Blendenrahmens
- 20: Blendenöffnung
- 22: Blendenöffnung
- 24: Fuß des Blendenrahmens
- 26: Hohlraum
- 28: Hohlraum
- 30: Trennwand
- 32: Abdeckung
- 34: Oberseite der Abdeckung
- 35: Unterseite der Abdeckung
- 36: optischer Weg
- 37: Finger eines Benutzers
- 38: Durchgangsöffnung
- 40: Auswerteschaltung
- 42: Mikroprozessor

## Patentansprüche

1. Berührungsempfindlicher Tastschalter (10), mit
einem optischen Sensor, der einen elektromagnetische Strahlung aussendenden Sender (14) und einen elektromagnetische Strahlung empfangenden Empfänger (16) enthält und der hinter einer für die elektromagnetische Strahlung zumindest teildurchlässigen Abdeckung (32) angeordnet ist; und
einer Auswerteschaltung (40) zum Auswerten eines von dem Empfänger (16) des optischen Sensors erzeugten Messsignals (V_{E}) und Erzeugen eines Auswertesignals (V_{IN}),
**dadurch gekennzeichnet,**
**dass** ferner eine Einrichtung (32, 38) zum Leiten eines Teils der von dem Sender (14) ausgesendeten elektromagnetischen Strahlung auch ohne Betätigung des Tastschalters (10) zum Empfänger (16) vorgesehen ist; und
**dass** die Auswerteschaltung (40) in Abhängigkeit von einem erfassten Grundpegel des Auswertesignals (V_{IN}) eine Fehlfunktion des optischen Sensors beurteilt, wenn während eines Sendetakts (tₐ - t_{b}) des Senders (14) keine Änderung des Auswertesignalpegels (V_{IN}) der Auswerteschaltung (40) erfasst wird.

2. Tastschalter nach Anspruch 1,
**dadurch gekennzeichnet,**
**dass** die Einrichtung eine zumindest teildurchlässige Durchgangsöffnung (38) einer Trennwand (30) eines Blendenrahmens (18) zwischen dem Sender (14) und dem Empfänger (16) aufweist.

3. Tastschalter nach Anspruch 1 oder 2,
**dadurch gekennzeichnet,**
**dass** die Einrichtung die Abdeckung (32) aufweist, die derart ausgebildet ist, dass ein Teil der von dem Sender (14) ausgesendeten Strahlung an der vorderen und/oder der hinteren Oberfläche (34, 35) der Abdeckung in Richtung zum Empfänger (16) reflektiert wird.

4. Berührungsempfindlicher Tastschalter (10), mit
einem optischen Sensor, der einen elektromagnetische Strahlung aussendenden Sender (14) und einen elektromagnetische Strahlung empfangenden Empfänger (16) enthält und der hinter einer für die elektromagnetische Strahlung zumindest teildurchlässigen Abdeckung (32) angeordnet ist; und
einer Auswerteschaltung (40) zum Auswerten eines von dem Empfänger (16) des optischen Sensors erzeugten Messsignals (V_{E}) und Erzeugen eines Auswertesignals (V_{IN}),
**dadurch gekennzeichnet,**
**dass** die Auswerteschaltung (40) ferner eine Einrichtung (Q2, R2) zum Umschalten eines Messbereichs des Auswertesignals (V_{IN}) aufweist; und
**dass** die Auswerteschaltung (40) in Abhängigkeit von einem erfassten Grundpegel des Auswertesignals (V_{IN}) eine Fehlfunktion des optischen Sensors beurteilt, wenn während eines Umschalttakts (t_{c} - t_{d}) des Grundpegels des Auswertesignals (V_{IN}) keine Änderung des Auswertesignalpegels (V_{IN}) der Auswerteschaltung (40) erfasst wird.

5. Tastschalter nach Anspruch 4,
**dadurch gekennzeichnet,**
**dass** die Auswerteschaltung (40) eine Spannungsteilerschaltung aufweist, die aus einem ersten Widerstand (R1) und einem ersten Transistor (Q1) gebildet wird, wobei der erste Transistor (Q1) durch das Messsignal (V_{E}) des Empfängers gesteuert wird und das Auswertesignal (V_{IN}) der Auswerteschaltung zwischen dem ersten Widerstand (R1) und dem ersten Transistor (Q1) abgegriffen wird; und
**dass** die Einrichtung eine Einrichtung (Q2, R2) zum Verändern des Spannungsteilungsverhältnisses ist.

6. Tastschalter nach Anspruch 5,
**dadurch gekennzeichnet,**
**dass** die Einrichtung eine Reihenschaltung eines zweiten Transistors (Q2) und eines zweiten Widerstandes (R2) aufweist, die parallel zu dem ersten Widerstand (R1) geschaltet ist, wobei der zweite Transistor (Q2) während des Umschalttakts (t_{c} - t_{d}) leitend gesteuert wird.

7. Tastschalter nach Anspruch 5 oder 6,
**dadurch gekennzeichnet,**
**dass** in der Auswerteschaltung (40) parallel zu dem ersten Transistor (Q1) ein dritter Widerstand (R3) geschaltet ist.

8. Berührungsempfindlicher Tastschalter (10), mit
einem optischen Sensor, der einen elektromagnetische Strahlung aussendenden Sender (14) und einen elektromagnetische Strahlung empfangenden Empfänger (16) enthält und der hinter einer für die elektromagnetische Strahlung zumindest teildurchlässigen Abdeckung (32) angeordnet ist; und
einer Auswerteschaltung (40) zum Auswerten eines von dem Empfänger (16) des optischen Sensors erzeugten Messsignals (V_{E}) und Erzeugen eines Auswertesignals (V_{IN}),
**dadurch gekennzeichnet,**
**dass** ferner eine Einrichtung (32, 38) zum Leiten eines Teils der von dem Sender (14) ausgesendeten elektromagnetischen Strahlung auch ohne Betätigung des Tastschalters (10) zum Empfänger (16) vorgesehen ist;
**dass** die Auswerteschaltung (40) ferner eine Einrichtung (Q2, R2) zum Umschalten eines Messbereichs des Auswertesignals (V_{IN}) aufweist; und
**dass** die Auswerteschaltung (40) in Abhängigkeit von einem erfassten Grundpegel des Auswertesignals (V_{IN}) eine Fehlfunktion des optischen Sensors beurteilt, wenn während eines Sendetakts (tₐ - t_{b}) des Senders (14) und/oder während eines Umschalttakts (t_{c} - t_{d}) des Grundpegels des Auswertesignals (V_{IN}) keine Änderung des Auswertesignalpegels (V_{IN}) der Auswerteschaltung (40) erfasst wird.

9. Tastschalter nach Anspruch 8,
**dadurch gekennzeichnet,**
**dass** die Einrichtung (32, 38) nach einem der Ansprüche 2 und 3 ausgebildet ist.

10. Tastschalter nach Anspruch 8 oder 9,
**dadurch gekennzeichnet,**
**dass** die Einrichtung (Q2, R2) nach einem der Ansprüche 5 bis 7 ausgebildet ist.

11. Tastschalter nach einem der vorherigen Ansprüche,
**dadurch gekennzeichnet,**
**dass** die elektromagnetische Strahlung Infrarot-Strahlung ist.
